(19) Europäisches Patentamt
European Patent Office
Office européen des brevets

(11) EP 1 681 907 A1

(12) EUROPEAN PATENT APPLICATION
published in accordance with Art. 158(3) EPC

(43) Date of publication:
19.07.2006 Bulletin 2006/29

(51) Int Cl.:
*H05B 33/04* (1968.09)    *H05B 33/02* (1968.09)
*H05B 33/12* (1968.09)    *H05B 33/14* (1968.09)

(21) Application number: 04793216.5

(22) Date of filing: 29.10.2004

(86) International application number:
PCT/JP2004/016108

(87) International publication number:
WO 2005/046291 (19.05.2005 Gazette 2005/20)

(84) Designated Contracting States:
AT BE BG CH CY CZ DE DK EE ES FI FR GB GR
HU IE IT LI LU MC NL PL PT RO SE SI SK TR

(30) Priority: 07.11.2003 JP 2003378344

(71) Applicant: IDEMITSU KOSAN CO., LTD.
Tokyo 100-8321 (JP)

(72) Inventors:
• FUKUDA, Masahiko
2990293 (JP)

• INOUE, Kazuyoshi
2990293 (JP)
• EIDA, Mitsuru
2990293 (JP)
• KUMA, Hitoshi
2990293 (JP)

(74) Representative: Gille Hrabal Struck Neidlein Prop
Roos
Brucknerstrasse 20
40593 Düsseldorf (DE)

(54) BARRIER FILM FOR LIGHT-EMITTING DISPLAY AND METHOD FOR PRODUCING SAME

(57) A barrier film which can effectively protect an organic EL device, an efficient method for producing the barrier film, and a light-emitting display exhibiting excellent durability in which a non-emission area such as the dark spot occurs to only a small extent are provided.

A method for producing a barrier film for light-emitting displays including a glass material containing three or more components, the barrier film being formed by a vapor deposition method. A light-emitting display including a supporting substrate 1, an emitting layer 2, and the barrier film 3 produced by the method. The barrier film can be produced with a target containing 50 to 90 wt% of silicon oxide, 5 to 20 wt% of boron oxide and 1 to 10 wt% of aluminum oxide by sputtering method.

FIG. 1

EP 1 681 907 A1

**Description**

TECHNICAL FIELD

The invention relates to a barrier film for light-emitting displays and a method for producing the same. The invention also relates to a light-emitting display, such as an organic EL display, including the barrier film.

BACKGROUND ART

An organic EL display includes an organic EL device in which an organic luminescent medium is placed between opposing electrodes. When voltage is applied between the electrodes of the organic EL device, electrons injected from one electrode and holes injected from the other electrode recombine in the organic emitting layer in the organic luminescent medium. The organic luminescent molecule in the organic emitting layer is excited to an excited state by the recombination energy, and then returns to the ground state from the excited state. The organic EL device emits light by releasing the energy.

The organic EL display formed by the organic EL device is a completely solid-state device, exhibits excellent visibility, and allows a reduction in weight and thickness. Moreover, the organic EL display can be driven at a low voltage of only several volts. Accordingly, the organic EL display is expected to be used as a full-color display and has been extensively researched.

However, since the organic EL device is susceptible to water and oxygen entering from the outside or water and gas generated from other constituent members of the device, a non-emission region or a non-emission point (dark spot) occurs in the emission region. Moreover, the size of the dark spot increases with time due to water, gas components, and the like entering the device. The intensity of light emitted from the organic EL device decreases with time due to an increase in the size of the dark spot.

Various attempts have been made to prevent the progress of oxidation caused by the entrance of water and oxygen to increase the lifetime of the organic EL device.

For example, JP-A-10-12383 and JP-A-8-279394 propose disposing a transparent insulating inorganic oxide layer having a thickness of 0.01 to 200 μm between the color conversion layer and the organic EL device.

JP-A-11-97169 discloses an organic EL device including a protective layer formed of a glass material in which a host material which can independently form an amorphous structure is doped with impurities as a guest material.

DISCLOSURE OF THE INVENTION

However, these technologies require further improvement, and a barrier film which can more effectively protect the organic EL device and an efficient production method for the barrier film have been in demand.

Accordingly, an object of the invention is to provide a barrier film which can effectively protect the organic EL device and an efficient method for producing the barrier film.

Another object of the invention is to provide a light-emitting display exhibiting excellent durability in which a non-emission area such as the dark spot occurs to only a small extent.

According to the invention, the following barrier film for light-emitting displays and the like are provided.

1. A method for producing a barrier film for light-emitting displays comprising a glass material comprising three or more components, the method comprising forming the barrier film by a vapor deposition method.
2. The method according to 1, wherein a raw material for the barrier film is the glass material comprising three or more components.
3. The method according to 2, wherein the glass material of the raw material comprises at least silicon, boron, and aluminum.
4. The method according to 2 or 3, wherein the glass material of the raw material comprises at least silicon oxide, boron oxide, and aluminum oxide.
5. The method according to any one of 2 to 4, wherein the glass material of the raw material comprises at least silicon oxide, boron oxide, aluminum oxide, and an alkali metal oxide or an alkaline earth metal oxide.
6. The method according to 1, wherein the glass material of the raw material of 5 and a rare earth element metal oxide are used in combination.
7. The method according to 4, wherein the glass material of the raw material comprises 50 to 90 wt% of the silicon oxide, 5 to 20 wt% of the boron oxide, and 1 to 10 wt% of the aluminum oxide.
8. The method according to any one of 2 to 7, wherein the barrier film is formed by a sputtering method with a target comprising the glass material of the raw material.
9. The method according to any one of 1 to 8, wherein the barrier film is a barrier film for organic electroluminescent displays.

10. A barrier film for light-emitting displays produced by the method according to any one of 1 to 9.

11. The barrier film according to 10, having a water vapor transmission rate of less than 0.01 g/m$^2$·24hr.

12. A color conversion substrate for light-emitting displays comprising a supporting substrate, a color conversion layer which converts and/or adjusts the color of received light, and the barrier film of 10 or 11 in this order.

13. A light-emitting display comprising a supporting substrate, a color conversion layer which converts and/or adjusts the color of received light, the barrier film of 10 or 11., and an emitting layer in this order.

14. A light-emitting display comprising a supporting substrate, an emitting layer, and the barrier film of 10 or 11 in this order.

15. A supporting substrate or opposite substrate for light-emitting displays wherein the barrier film of 10 or 11 is formed on one side or both sides of the substrate.

16. The supporting substrate or opposite substrate according to 15 being a plastic substrate.

17. The light-emitting display according to any one of 12 to 14 wherein the supporting substrate is a glass substrate or the supporting substrate of 16.

According to the invention, a barrier film which can effectively protect an organic EL device and an efficient method for producing the barrier film can be provided.
According to the invention, a light-emitting display exhibiting excellent durability can be provided in which a non-emission area such as the dark spot occurs to only a small extent.

BRIEF DESCRIPTION OF THE DRAWINGS

FIG. 1 is a view showing an organic EL display according to one embodiment of the invention.

FIG. 2 is a view showing an organic EL display according to another embodiment of the invention.
FIG. 3 is a view showing steps of forming an organic EL display of Example 1.
FIG. 4 is a view showing steps of forming a polysilicon TFT.
FIG. 5 is a circuit diagram showing an electric switch connection structure including a polysilicon TFT.
FIG. 6 is a planar perspective view showing an electric switch connection structure including a polysilicon TFT.
FIG. 7 is a view showing steps of forming an organic EL display of Example 3.

BEST MODE FOR CARRYING OUT THE INVENTION

First Embodiment

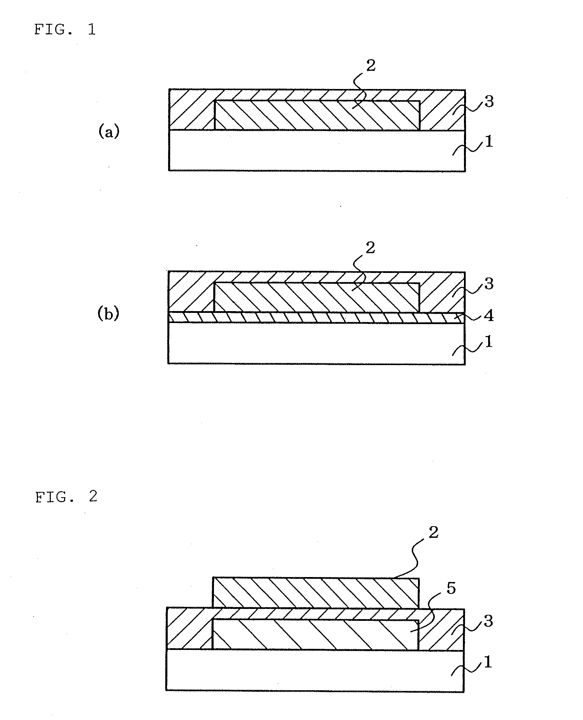

FIGS. 1(a) and 1(b) illustrate an organic EL display according to one embodiment of the invention.
In the organic EL display shown in FIG. 1(a), an organic EL device 2 and a barrier film 3 are formed on a supporting substrate 1.
The barrier film 3 protects the organic EL device 2 from water, oxygen, and the like entering from the outside. Specifically, the barrier film 3 functions as a sealing material for the organic EL device.
The barrier film 3 preferably has a low water vapor transmission rate of less than 0.01 g/m$^2$·24hr.
The water vapor transmission rate is measured according to JIS Z 0208 "Testing methods for determination of the water vapor transmission rate of moisture-proof packaging materials (dish method)".
In more detail, when maintaining the atmosphere on one side of a moisture-proof packaging material (boundary surface) at a relative humidity of 90% and maintaining the atmosphere on the other side in a dry state using a moisture absorbent at a temperature of 25°C, the weight (g/m$^2$) of water vapor passing through the boundary surface within 24 hours is the water vapor transmission rate of the moisture-proof packaging material.
The barrier film 3 includes a glass material including three or more components. The components of the glass material are selected from oxides, sulfides, halides (e.g. fluorides and iodides), oxynitrides, chalcogenides, element atoms, and the like. The components of the glass material are preferably selected from oxides, sulfides, and element atoms, and still more preferably from oxides.
In the glass material, at least one substance selected from element atoms, oxides, and sulfides is generally present between the molecules of an oxide or a sulfide having a three-dimensional network structure.
The barrier film according to the invention may be produced by a vapor deposition method. As the raw material, a glass material, a crystalline material, or the like containing various compounds may be used. Or, a glass material thin film may be obtained using a method of causing a reactive gas (e.g. O$_2$, N$_2$, or CH$_4$) to react with a metal. A glass material including three or more components is preferably used as the raw material.
As examples of the vapor deposition method, a sputtering method, an ion beam method, an ion plating method, and the like can be given. The sputtering method includes facing target sputtering, magnetron sputtering, ion beam sputtering, and ECR sputtering.

The barrier film is preferably produced by the sputtering method using a target formed of a glass material.

The glass material used as the raw material according to the invention includes at least three components, and preferably includes three or more oxides.

As examples of the glass material, soda-lime glass, barium-strontium containing glass, lead glass, aluminosilicate glass, borosilicate glass, and barium borosilicate glass can be given. As the glass material, aluminosilicate glass, borosilicate glass, and rare earth metal containing glass are preferable. The name of the glass is in accordance with "Dictionary of Glass" (edited by Sumio Sakka, Asakura Shoten, 1988). As the aluminosilicate glass, "Corning 1737" manufactured by Corning may be used. As the borosilicate glass, "Pyrex® " manufactured by Corning may be used. As the rare earth metal containing glass, Vycor manufactured by Corning may be used. Products available from other manufacturers may also be used.

In the invention, the glass material used as the raw material preferably includes at least silicon, boron, and aluminum. Specific examples of such a glass material are given below.

(1) Glass material including at least silicon oxide, boron oxide, and aluminum oxide
(2) Glass material including at least silicon oxide, boron oxide, aluminum oxide, and alkali metal oxide
(3) Glass material including at least silicon oxide, boron oxide, aluminum oxide, and alkaline earth metal oxide
(4) Glass material including at least silicon oxide, boron oxide, aluminum oxide, and rare earth element metal oxide

The glass material (1) preferably includes 50 to 90 wt% of silicon oxide, 5 to 20 wt% of boron oxide, and 1 to 10 wt% of aluminum oxide, and more preferably includes 60 to 90 wt% of silicon oxide, 5 to 20 wt% of boron oxide, and 1 to 10 wt% of aluminum oxide.

As shown in FIG. 1 (b), a second barrier film 4 maybe provided between the supporting substrate 1 and the organic EL device 2. In particular, when the supporting substrate 1 is a plastic film, water and gas components generated from the film can be confined in the film and water and oxygen passing through the film can be blocked by providing the barrier film 4 on the supporting substrate 1.

The organic EL device may be sealed by attaching an opposite substrate formed by forming the barrier film on one side or both sides of a substrate made of plastic or the like to the organic EL device substrate instead of directly forming the barrier film 3 on the organic EL device by the vapor deposition method. As the material for the opposite substrate, the material used for the supporting substrate described later may be used.

Second Embodiment

FIG. 2 shows an organic EL display according to another embodiment of the invention.

In the organic EL display shown in FIG. 2, a color conversion layer 5, the barrier film 3, and the organic EL device 2 are formed on the supporting substrate 1. A color conversion substrate is formed by the supporting substrate 1, the color conversion layer 5, and the barrier film 3.

Water and gas components generated from the color conversion layer 5 are confined in the color conversion layer 5 by the barrier film 3, whereby the organic EL device 2 is protected.

The material and the production method for the barrier film 3 are the same as described in the first embodiment.

In the second embodiment, the barrier film 3 is formed on the color conversion layer 5. Note that the barrier film 3 may also be formed on the organic EL device 2 in order to seal the organic EL device 2. The barrier film 3 may also be formed between the supporting substrate 1 and the color conversion layer 5.

The organic EL display according to the second embodiment is a bottom emission type in which the color conversion layer 5 adjusts and/or converts the color of light emitted from the organic EL device 2 and the light is emitted from the supporting substrate 1. The organic EL display according to the second embodiment may be a top emission type in which the organic EL device 2 and the color conversion layer 5 are formed on the supporting substrate 1 and light is emitted from the side opposite to the supporting substrate 1. In this case, the barrier film 3 may be formed between the supporting substrate and the organic EL device, between the organic EL device and the color conversion layer, or on the color conversion layer in order to protect the organic EL device 2.

According to the above-described embodiments, a film exhibiting improved gas barrier properties can be obtained by using the glass material so that a reduction in the emission display area or expansion of a dark spot occurring when continuously driving (displaying) the organic EL device can be prevented, whereby an organic EL display exhibiting excellent durability can be obtained.

A mixed gas is introduced when depositing an $SiO_x$ film or an SiON film. On the other hand, since only an Ar gas is applied to a glass target when using a glass material, the production stability is increased, whereby mass production can be achieved.

JP-A-10-12383 and JP-A-8-279394 cited above disclose a transparent insulating thin glass plate, but do not disclose a film production method by vapor deposition, which is the feature of the invention. Since the barrier film according to the invention is deposited by the vapor deposition method, the barrier film shows improved adhesion to the supporting substrate and exhibits high impact resistance. For example, the barrier film ensures excellent connection stability of ICs formed by chip on film (COF) technology or the like. Moreover, the barrier film ensures high large screen uniformity and mass production stability (sealing breakage from the peripheral adhesive section does not occur).

JP-A-11-97169 discloses a method using the vapor deposition method, but the examples do not disclose a barrier film including a glass material including three or more components. A glass material including three or more components exhibits excellent stability. JP-A-11-97169 discloses sealing an organic EL device, but does not disclose sealing a color conversion layer. In JP-A-11-97169, the host and guest raw materials are independent, and the guest is doped during deposition (vapor deposition). According to the invention, the glass material in which the guest is mixed is deposited as the raw material. As a result, a barrier film having the properties of the glass material used as the rawmaterial is obtained, whereby the large screen uniformity and mass production stability are increased.

The supporting substrate, the organic EL device, and the color conversion layer used in the above-described embodiments are not particularly limited. These members are described below.

As examples of the material for the supporting substrate, a glass plate, a metal plate, a ceramic plate, a plastic plate (e.g. polycarbonate resin, acrylic resin, vinyl chloride resin, polyethylene terephthalate resin, polyimide resin, polyester resin, epoxy resin, phenol resin, silicone resin, fluororesin, and polyethersulfone resin), and the like can be given.

The organic EL device generally includes an organic luminescent medium, and an anode and a cathode provided on either side of the organic luminescent medium.
As the emitting material for the organic luminescent medium, a p-quarterphenyl derivative, p-quinquephenyl derivative, benzodiazole compound, benzimidazole compound, benzoxazole compound, metal-chelated oxynoid compound, oxadiazole compound, styrylbenzene compound, distyrylpyrazine derivative, butadiene compound, naphthalimido compound, perylene derivative, aldazine derivative, pyraziline derivative, cyclopentadiene derivative, pyrrolopyrrolederivative, styrylaminederivative, coumarin compound, aromatic dimethylidene compound, metal complex having an 8-quinolinol derivative as a ligand, polyphenyl compound, and the like may be used either individually or in combination of two or more.

As the material for the anode, a material having a large work function is preferable. For example, indiumtin oxide (ITO), indium zinc oxide (IZO), copper indium (CuIn), tin oxide ($SnO_2$), zinc oxide (ZnO), antimony oxide ($Sb_2O_3$, $Sb_2O_4$, $Sb_2O_5$), aluminum oxide ($Al_2O_3$), and the like may be used either individually or in combination of two or more.

As the material for the cathode, a material having a small work function is preferable. For example, an electrode material such as sodium, sodium-potassium alloy, cesium, magnesium, lithium, magnesium-silver alloy, aluminum, aluminum oxide, aluminum-lithium alloy, indium, rare earth metal, a mixture of the above-mentioned metal and an organic luminescent medium material, or a mixture of the above-mentioned metal and an electron injecting layer material is preferably used either individually or in combination of two or more.

As the color conversion layer which adjusts and/or converts the color of light emitted from the organic EL device, (1) a color conversion layer formed by a color filter, (2) a color conversion layer formed by a fluorescent medium, and (3) a color conversion layer formed by combining a color filter and a fluorescent medium can be given.
The color filter has the function of adjusting the color or improving the contrast by decomposing or blocking light.
As the material for the color filter, dyes given below, a solid material obtained by dissolving or dispersing the dye given below in a binder resin, and the like can be given.
Red (R) dye:

A perylene pigment, lake pigment, azo pigment, quinacridone pigment, anthraquinone pigment, anthracene pigment, isoindoline pigment, and isoindolinone pigment, diketopyrrolopyrrole pigment, or a mixture of at least two of these pigments may be used.
Green (G) dye:
A halogen-multisubstituted phthalocyanine pigment, halogen-multisubstituted copper phthalocyanine pigment, triphenylmethane basic dye, azo pigment, isoindoline pigment, isoindolinone pigment, or a mixture of at least two of these pigments may be used.
Blue (B) dye:
A copper phthalocyanine pigment, indanthrone pigment, indophenol pigment, cyanine pigment, dioxazine pigment, or a mixture of at least two of these pigments may be used.

As the binder resin used as the material for the color filter, it is preferable to use a transparent material (having a transmittance of 50% or more in the visible light region). As examples of such a material, transparent resins (polymers) such as polymethyl methacrylate, polyacrylate, polycarbonate, polyvinyl alcohol, polyvinylpyrrolidone, hydroxyethylcellulose, and carboxymethylcellulose can be given. These resins may be used either individually or in combination of two or more.

The fluorescent medium has the function of absorbing light emitted from the organic EL device and emitting fluorescence having a longer wavelength.

The material for the fluorescent medium includes fluorescent dye and a resin or only fluorescent dye. As the material including fluorescent dye and a resin, a solid material obtained by dissolving or dispersing fluorescent dye in a pigment resin and/or a binder resin can be given.

Specific examples of fluorescent dye are given below. As examples of fluorescent dye which converts near ultraviolet to violet light emitted from the organic EL device into blue light, stilbene dye such as 1,4-bis(2-methylstyryl)benzene (hereinafter called "Bis-MBS") and trans-4,4'-diphenylstilbene (hereinafter called "DPS"), and coumarin dye such as 7-hydroxy-4-methylcoumarin (hereinafter called "coumarin 4") can be given.

As examples of fluorescent dye which converts blue, blue green, or white light emitted from the organic EL device into green light, coumarin dye such as 2,3,5,6-1H,4H-tetrahydro-8-trifluoromethylquinolizino(9,9a, 1-gh)coumarin (hereinafter called "coumarin 153"), 3-(2'-benzothiazolyl)-7-diethylaminocoumarin (hereinafter called "coumarin 6"), and 3-(2'-benzimidazolyl)-7-N,N-diethylaminocoumarin (hereinafter called "coumarin 7"), basic yellow 51 which is also a coumarin dye, and naphthalimido dye such as solvent yellow 11 and solvent yellow 116 can be given.

As examples of fluorescent dye which converts blue to green light or white light emitted from the organic EL device into orange to red light, cyanine dye such as 4-dicyanomethylene-2-methyl-6-(p-dimethylaminostyryl)-4H-pyrane (hereinafter called "DCM"), pyridine dye such as 1-ethyl-2-(4--(p-dimethylaminophenyl)-1,3-butadienyl)-pyridinium-perchlorate (hereinafter called "pyridine 1"), rhodamine dye such as rhodamine B and rhodamine 6G, oxazine dye, basic violet 11, coumarin 6, and the like can be given.

As the binder resin, the binder resin used for the color filter may be used.

As the constituent members of the supporting substrate, the organic EL device, the color conversion layer, and the like, those disclosed in WO 02/017689, WO 03/043382, WO 03/069957, PCT/JP03/02798, Japanese Patent Application No. 2002-301852, and the like may be used.

(Example)

Example 1

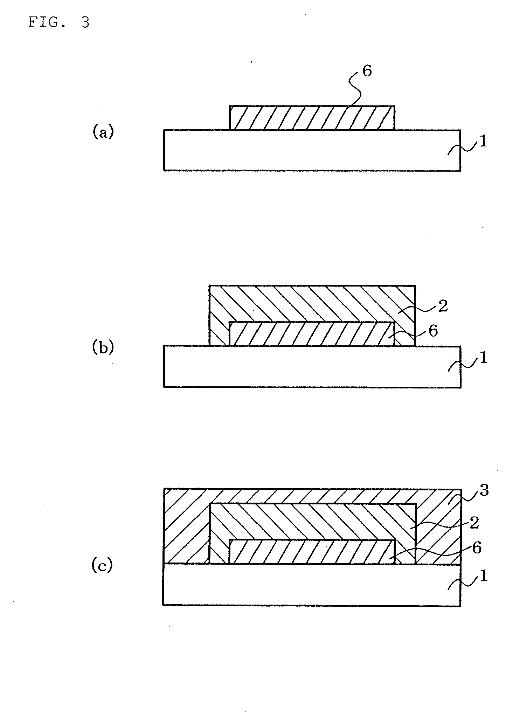

In Example 1, an organic EL display was produced by forming a TFT 6, the organic EL device 2, and the barrier film 3 on the supporting substrate 1, as shown in FIGS. 3(a) to 3(c).

(1) Fabrication of TFT (FIG. 3(a))

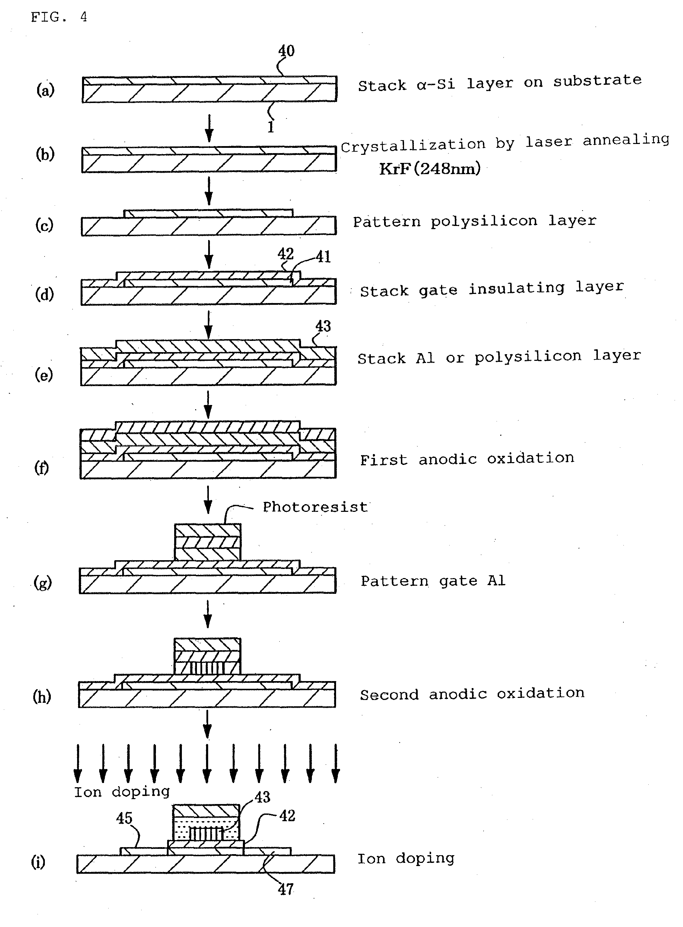

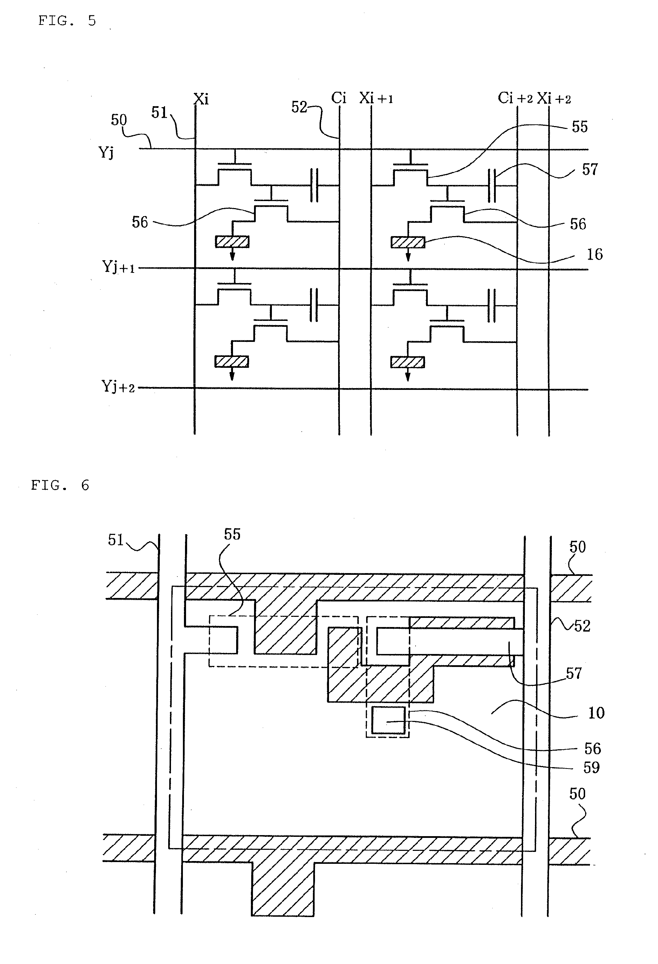

FIGS. 4(a) to 4(i) are views showing polysilicon TFT formation steps. FIG. 5 is a circuit diagram showing an electric switch connection structure including a polysilicon TFT, and FIG. 6 is a planar perspective view showing an electric switch connection structure including a polysilicon TFT.

An $\alpha$-Si layer 40 was stacked on a glass substrate 1 (OA$_2$ glass manufactured by Nippon Electric Glass Co., Ltd.) having dimensions of 112×143×1.1 mm by a method such as low pressure chemical vapor deposition (LPCVD) (FIG. 4(a)). Then, crystallization annealing was performed by applying laser light to the $\alpha$-Si layer 40 from an excimer laser such as a KrF (248nm) laser to form polysilicon (FIG. 4(b)). The polysilicon was patterned in the shape of an island by photolithography (FIG. 4 (c)). An insulating gate material 42 was stackedon the surfaces of the island-shaped polysilicon 41 and the substrate 1 by chemical vapor deposition (CVD) or the like to form a gate oxide insulating layer 42 (FIG. 4(d)). After depositing a gate electrode 43 by deposition or sputtering (FIG. 4 (e)), the gate electrode 43 was patterned and anodic oxidation was performed (FIGS. 4 (f) to 4 (h)). Then, doped regions (active layer) were formed by ion doping (ion implantation) to form a source 45 and a drain 47 to obtain a polysilicon TFT (FIG. 4(i)). The gate electrode 43 (and scan electrode 50 and bottom electrode of capacitor 57 shown in FIG. 6) was formed by Al, and the source 45 and the drain 47 of the TFT were an n$^+$-type.

After forming an interlayer dielectric (SiO$_2$ having a thickness of 500 nm on the active layer by a CRCVD method, a signal electrode 51, a common electrode 52, and a capacitor upper electrode (Al) were formed, a source electrode of a second transistor (Tr2) 56 was connected with the common electrode, and a drain of a first transistor (Tr1) 55 was connected with the signal electrode (FIGS. 5 and 6). The TFT and the electrode were connected after appropriately removing the interlayer dielectric SiO$_2$ by wet etching using hydrofluoric acid.

Then, Cr and ITO were deposited by sputtering to a thickness of 2000 angstroms and 1300 angstroms, respectively. A positive-tone resist ("HPR204" manufactured by Fujifilm Arch Co., Ltd.) was applied to the substrate by spin coating, and ultraviolet rays were applied through a photomask so that a 90×320$\mu$m dot-shaped pattern was formed. The resist was then developed using a tetramethylammonium hydroxide (TMAH) developer and baked at 130°C to obtain a resist pattern.

The exposed ITO was etched using an ITO etchant containing 47% hydrobromic acid, and the Cr was etched using a ceric ammonium nitrate/perchloric acid aqueous solution ("HCE" manufactured by Nagase & Company, Ltd.). The resist was treated with a stripper containing ethanolamine as the major component ("N303" manufactured by Nagase & Company, Ltd.) to obtain a Cr/ITO pattern (lower electrode: anode).

In this step, the second transistor Tr2 56 and the lower electrode 10 were connected through an opening 59 (FIG. 6). As a interlayer insulator, a negative-tone resist ("V259BK" manufactured by Nippon Steel Chemical Co., Ltd.) was applied by spin coating, irradiated with ultraviolet rays, and developed using a tetramethylammonium hydroxide (TMAH) developer. The resulting resist was baked at 180°C to form an interlayer insulator of an organic film which covered the edge of the Cr/ITO (ITO opening was $70 \times 200$ μm).

(2) Fabrication of organic EL device (FIG. 3(b))
The substrate on which the interlayer insulator was formed was subjected to ultrasonic cleaning in pure water and isopropyl alcohol, dried by air blowing, and subjected to UV cleaning.

The TFT substrate was transferred to an organic deposition device (manufactured by ULVAC, Inc.) and secured on a substrate holder. Each molybdenum heating boat was charged in advance with 4,4',4"-tris[N-(3-methylphenyl)-N-phenylamino]triphenylamine (MTDATA) and 4,4'-bis[N-(1-naphthyl)-N-phenylamino]biphenyl (NPD) as a hole injecting material, 4,4'-bis(2,2-diphenylvinyl)biphenyl (DPVBi) as a host of an emitting material, 1,4-bis[4-(N,N-diphenylaminostyrylbenzene)] (DPAVB) as a dopant, and tris(8-quinolinol)aluminum (Alq) and Li as an electron injecting material and a cathode. An IZO (indium zinc oxide) target was placed in another sputtering container as a cathode lead electrode.

After reducing the pressure inside the vacuum chamber to $5 \times 10^{-7}$ torr, the layers from the hole injecting layer to the cathode were stacked as described below without breaking the vacuum.

As the hole injecting layer, MTDATA was deposited to a thickness of 60 nm at a deposition rate of 0.1 to 0.3 nm/sec and NPD was deposited to a thickness of 20 nm at a deposition rate of 0.1 to 0.3 nm/sec. As the emitting layer, DPVBi and DPAVB were codeposited to a thickness of 50 nm at a deposition rate of 0.1 to 0.3 nm/sec and 0.03 to 0.05 nm/sec, respectively. As the electron injecting layer, Alq was deposited to a thickness of 20 nm at a deposition rate of 0.1 to 0.3 nm/sec. As the cathode, Alq and Li were codeposited to a thickness of 20 nm at a deposition rate of 0.1 to 0.3 nm/sec and 0.005 nm/sec, respectively.

Then, the substrate was transferred to the sputtering container, and IZO was deposited to a thickness of 200 nm at a deposition rate of 0.1 to 0.3 nm/sec as the lead electrode of the cathode to obtain an organic EL device.

(3) Formation of barrier film (FIG. 3(c))
A barrier film was deposited on the upper electrode of the organic EL device by sputtering using Corning 1737 as a target . The barrier film was deposited to a thickness of 300 nm at a sputtering pressure of 0.7 Pa and a sputtering output of 1 kW. Table 1 shows the composition of Corning 1737 (Corning' s catalog values). Table 2 shows the atomic composition of Corning 1737 (conversion from Corning's catalog values) and the elemental analysis values of the barrier film (X-ray photoelectron spectrometer: XPS). A barrier film having a composition approximately the same as that of the target was obtained. After forming the barrier film as the EL sealing film, the substrate was transferred to a dry box in which dry nitrogen was circulated while preventing the substrate from contacting the atmosphere. In order to prevent occurrence of external physical contact, a glass lid was attached to the supporting substrate in the dry box using a cationic curable adhesive ("3102" manufactured by Three Bond Co., Ltd.) so that the organic EL device was entirely covered. An organic EL device substrate was thus obtained.

(4) Reliability evaluation of organic EL display
An active organic EL display (FIG. 3 (c)) was produced as described above. A DC voltage of 7 V was applied between the lower electrode (ITO/Cr) and the upper electrode (IZO) (lower electrode: (+), upper electrode: (-)). As a result, emission of light occurred at the intersecting point (pixel) of the electrodes.

After subjecting the organic EL display to a 85°C storage test for 500 hours, the reduction rate of the emitting pixel area given below was measured using a microscope. As a result, the reduction rate was 3%. This indicates that an organic EL display exhibiting excellent durability was obtained.

```
Reduction rate (%) = (emitting pixel area before test - emitting pixel area after test) × 100 / emitting pixel area before test
```

(5) Measurement of water vapor transmission rate
The water vapor transmission rate was measured according to JIS Z 0208. Specifically, the barrier film obtained in (3) was deposited on the upper surface of a polyethylene terephthalate (PET) film to obtain a sample. The steam transmittance was measured according to the method described in JIS Z 0208. As a result, the steam transmittance was 0.001 $g/m^2 \cdot 24hr$ (measurement lower limit) or less. Specifically, it was confirmed that the organic EL display exhibited performance required for an organic EL display.

Example 2

An organic EL display was produced in the same manner as in Example 1 except for forming the barrier film using Pyrex® as the target. The reliability evaluation and the steam transmittance measurement were conducted in the same manner as in Example 1. The results are shown in Table 3. Table 1 shows the composition of Pyrex® (Corning's catalog values). Table 2 shows the elemental analysis values of the barrier film.

Comparative Example 1

An organic EL display was produced in the same manner as in Example 1 except that the barrier film was not formed. The reliability evaluation and the steam transmittance measurement were conducted in the same manner as in Example 1. The results are shown in Table 3.

Comparative Example 2

A glass plate having a thickness of 50 $\mu$m was attached to the organic EL device instead of depositing the barrier film by sputtering (Example 1).
In more detail, the organic EL device substrate and the glass plate were transferred to a dry box in which dry nitrogen was circulated, and a cationic photocurable adhesive ("3102" manufactured by Three Bond Co. , Ltd.) was applied to the periphery of the display section (emitting section) on the organic EL device substrate using a dispenser. The organic EL device substrate and the glass plate were attached by irradiation according to an alignment mark, and an area corresponding to the display section was filled with an inert liquid (fluorinatedhydrocarbon: "FC70" manufactured by Sumitomo 3M Ltd.) degassed in advance.
The resulting organic EL display was subjected to the reliability evaluation and the steam transmittance measurement in the same manner as in Example 1. As a result, a reduction in pixel size was observed near the display section.
It is estimated that the pixel size was reduced because cracks occurred in the glass plate (thickness: 50 $\mu$m) in the sealing portion to cause water and the like to enter the organic EL display section from the outside.

Example 3

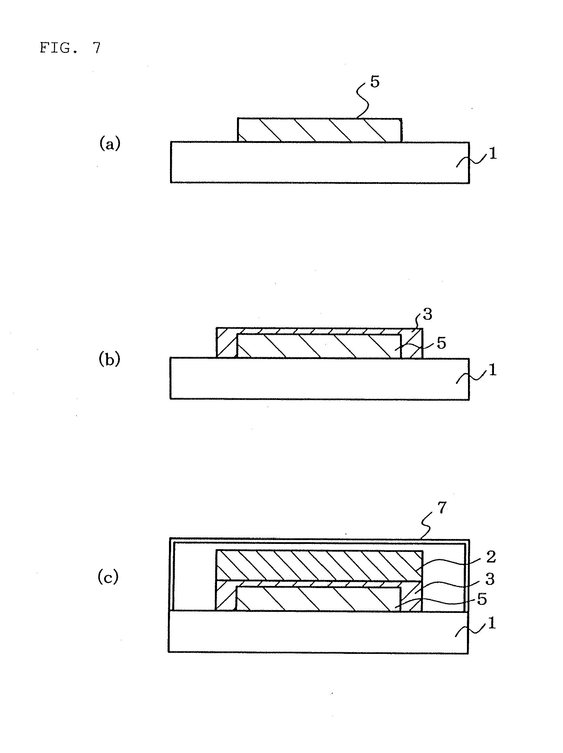

In Example 3, an organic EL display was produced by forming the color conversion layer 5, the barrier film 3, the organic EL device 2, and a sealing member 7 on the supporting substrate 1, as shown in FIGS 7(a) to 7(c).
(1) Formation of color conversion layer (FIG. 7(a))
V259BK (manufactured by Nippon Steel Chemical Co., Ltd.) as the material for a black matrix (BM) was applied by spin coating to a supporting substrate (transparent substrate) (OA$_2$ glass manufactured by Nippon Electric Glass Co., Ltd.) having dimensions of 102×133×1.1 mm. Then, ultraviolet rays were applied through a photomask so that a lattice-shaped pattern was formed. The resist was then developed using a 2% sodium carbonate aqueous solution and baked at 200°C to obtain a black matrix (thickness: 1.5 $\mu$m) pattern.

V259B (manufactured by Nippon Steel Chemical Co., Ltd.) as the material for a blue color filter was applied by spin coating. Then, ultraviolet rays were applied through a photomask aligned with the BM so that 320 rectangular

stripe patterns (90-μm line and 240-μm gap) were obtained. The material was then developed using a 2% sodium carbonate aqueous solution and baked at 200°C to obtain a blue color filter (thickness: 1.5 μm) pattern.

V259G (manufactured by Nippon Steel Chemical Co., Ltd.) as the material for a green color filter was applied by spin coating. Then, ultraviolet rays were applied through a photomask aligned with the BM so that 320 rectangular stripe patterns (90-μm line and 240-μm gap) were obtained. The material was then developed using a 2% sodium carbonate aqueous solution and baked at 200°C to obtain a green color filter (thickness: 1.5 μm) pattern adjacent to the blue color filter.

V259R (manufactured by Nippon Steel Chemical Co., Ltd.) as the material for a red color filter was applied by spin coating. Then, ultraviolet rays were applied through a photomask aligned with the BM so that 320 rectangular stripe patterns (90-μm line and 240-μm gap) were obtained. The material was then developed using a 2% sodium carbonate aqueous solution and baked at 200°C to obtain a red color filter (thickness: 1.5 μm) pattern between the blue color filter and the green color filter.

As the material for a green fluorescent medium, ink was prepared by dissolving coumarin 6 in an acrylic negative-tone photoresist ("V259PA" manufactured by Nippon Steel Chemical Co., Ltd., solid content: 50%) in an amount of 0.04 mol/kg (solid content).

The ink was applied to the substrate by spin coating, and ultraviolet rays were applied to the ink in the area of the green color filter. The ink was then developed using a 2% sodium carbonate aqueous solution and baked at 200°C to form a green conversion film pattern (thickness: 10 μm) on the green color filter.

As the material for a red fluorescent medium, ink was prepared by dissolving 0.53 g of coumarin 6, 1.5 g of basic violet 11, and 1.5 g of rhodamine 6G in 100 g of an acrylic negative-tone photoresist ("V259PA" manufactured by Nippon Steel Chemical Co. , Ltd., solid content: 50%).

The ink was applied to the substrate by spin coating, and ultraviolet rays were applied to the ink in the area of the red color filter. The ink was then developed using a 2% sodium carbonate aqueous solution and baked at 180°C to form a red conversion film pattern (thickness: 10 μm) on the red color filter. A color conversion substrate was thus obtained.

An acrylic thermosetting resin ("V259PH" manufactured by Nippon Steel Chemical Co., Ltd.) was applied to the substrate by spin coating and then baked at 180°C to form a planarizing film (thickness: 12 μm).

(2) Formation of barrier film (FIG. 7(b))

A barrier film was deposited on the planarizing film by magnetron sputtering using Corning 1737 as a target. The barrier film was deposited to a thickness of 300 nm at a sputtering pressure of 0.7 Pa and a sputtering output of 500 W. A color conversion substrate was thus obtained.

(3) Fabrication of organic EL device (FIG. 7(c))

IZO was deposited by sputtering to a thickness of 200 nm on the color conversion substrate.

A positive-tone resist ("HPR204" manufactured by Fujifilm Olin Co., Ltd.) was applied to the substrate by spin coating, and ultraviolet rays were applied through a photomask so that a cathode lead portion and a 90-μm line and 20-μm gap stripe pattern were formed. The resist was then developed using a tetramethylammonium hydroxide (TMAH) developer and baked at 130°C to obtain a specific resist pattern.

The exposed IZO was etched using an IZO etchant (5% oxalic acid aqueous solution). The resist was treated with a stripper containing ethanolamine as the major component ("N303" manufactured by Nagase & Company, Ltd.) to obtain an IZO pattern (lower electrode: anode, number of lines: 960).

As a first interlayer insulator, a negative-tone resist ("V259PA" manufactured by Nippon Steel Chemical Co., Ltd.) was applied by spin coating, irradiated with ultraviolet rays through a photomask so that a specific pattern was formed, and developed using a TMAH developer. The resulting resist was baked at 160°C to form an interlayer insulator which covered the edge of the ITO (IZO opening was 70×290 μm).

As a second interlayer insulator (partition wall), a negative-tone resist ("ZPN1100" manufactured by Zeon Corporation) was applied by spin coating, irradiated with ultraviolet rays through a photomask so that a 20-pm line and 310-μm gap stripe pattern was formed, and postbaked. The negative-tone resist developed using a TMAH developer to obtain a second interlayer insulator (partition wall) of an organic film intersecting the IZO stripes at right angles.

The resulting substrate was subjected to ultrasonic cleaning in pure water and isopropyl alcohol, dried by air blowing, and subjected to UV cleaning.

The substrate was transferred to an organic deposition chamber (manufactured by ULVAC, Inc.) and secured on a substrate holder. Each molybdenum heating boat was charged in advance with 4,4',4"-tris[N-(3-methylphenyl)-N-phenylamino]triphenylamine (MTDATA) and 4,4'-bis [N- (1-naphthyl) -N-phenylamino] biphenyl (NPD) as a hole injecting material, 4,4'-bis(2,2-diphenylvinyl)biphenyl (DPVBi) as an emitting material, and tris (8-quinolinol) aluminum (Alq) as an electron injecting material. As a cathode, an AlLi alloy (Li concentration: 10 atm%) was provided on a tungsten filament.

After reducing the pressure inside the vacuum chamber to $5 \times 10^{-7}$ torr, the layers from the hole injecting layer to the cathode were stacked as described below without breaking the vacuum.

As the hole injecting layer, MTDATA was deposited to a thickness of 60 nm at a deposition rate of 0.1 to 0.3 nm/sec and NPD was deposited to a thickness of 20 nm at a deposition rate of 0.1 to 0.3 nm/sec. As the emitting layer, DPVBi was deposited to a thickness of 50 nm at a deposition rate of 0.1 to 0. 3 nm/sec. As the electron injecting layer, Alqwas deposited to a thickness of 20 nm at a deposition rate of 0.1 to 0.3 nm/sec. As the cathode, Al and Li were deposited to a thickness of 150 nm at a deposition rate of 0.5 to 1.0 nm/sec. The organic layer (hole injecting layer to electron injecting layer) and the cathode (upper electrode) were deposited using a mask. The cathode was formed so that the cathode could be connected with the IZO lead electrode formed in advance. The cathode had a pattern (number of lines: 240) automatically separated by the partition walls formed on the substrate.

After fabricating the organic EL device on the substrate as described above, a barrier film was formed in the same manner as in Example 1. Then, the substrate was transferred to a dry box in which dry nitrogen was circulated while preventing the substrate from contacting the atmosphere. In order to prevent occurrence of external physical contact, the display section was covered with a glass lid of the sealing substrate in the dry box, and the periphery of the display section was sealed by photocuring a cationically curable adhesive ("TB3102" manufactured by Three Bond Co., Ltd.).

(4) Reliability evaluation of organic EL display and measurement of water vapor transmission rate

A full color organic EL display (aperture ratio: 56%) was produced as described above in which the lower electrodes and the upper electrodes formed an XY matrix. A DC voltage of 7 V was applied between the lower electrode and the upper electrode (lower electrode: (+), upper electrode: (-)). As a result, emission of light occurred at the intersecting point (pixel) of the electrodes.

The organic EL display was subjected to the reliability evaluation and the water vapor transmission rate measurement in the same manner as in Example 1. The results are shown in Table 3.

Example 4

An organic EL display (FIG. 7 (c)) was produced in the same manner as in Example 3 except for forming the barrier film using Pyrex® used in Example 2 as the target. The reliability evaluation and the water vapor transmission rate measurement were conducted in the same manner as in Example 1. The results are shown in Table 3.

Example 5

An organic EL display (FIG. 7 (c)) was produced in the same manner as in Example 3 except for forming the barrier film using Pyrex® used in Example 2 and $CeO_2$ as the target. The reliability evaluation and the water vapor transmission rate measurement were conducted in the same manner as in Example 1. The results are shown in Table 3. The elemental analysis values of the barrier film formed are shown in Table 2.

Comparative Example 3

An organic EL display (FIG. 7 (c)) was produced in the same manner as in Example 3 except for forming the barrier film using SiO as the target and introducing a gas containing 90% of Ar gas, 5% of oxygen gas, and 5% of nitrogen gas. The reliability evaluation and the water vapor transmission rate measurement were conducted in the same manner as in Example 1. The results are shown in Table 3.

Comparative Example 4

An organic EL display (FIG. 7 (c)) was produced in the same manner as in Example 3 except for forming the barrier film using SiO as the target and introducing a gas containing 90% of Ar gas and 10% of nitrogen gas. The reliability evaluation and the water vapor transmission rate measurement were conducted in the same manner as in Example 1. The results are shown in Table 3.

Comparative Example 5

An organic EL display (FIG. 7 (c)) was produced in the same manner as in Example 3 except for forming the barrier film by sputtering using $SiO_2$ and $Al_2O_3$ as the target. The reliability evaluation and the water vapor transmission rate measurement were conducted in the same manner as in Example 1. The results are shown in Table 3. As a result, a variation in reduction in pixel size was observed.

Comparative Example 6

An organic EL display (FIG. 7 (c)) was produced in the same manner as in Example 3 except for forming the barrier film using $SiO_2$ and $CeO_2$ as the target. The reliability evaluation and the water vapor transmission measurement were conducted in the same mariner as in Example 1. The results are shown in Table 3.

Comparative Example 7

An organic EL display was produced in the same manner as in Example 3 except that the barrier film was not formed. The reliability evaluation and the steam transmittance measurement were conducted in the same manner as in Example 1. The results are shown in Table 3.

Example 6

In Example 6, an organic EL display was produced by forming the organic EL device 2 and the barrier film 3 on the supporting substrate 1, as shown in FIG. 1(a).
Fabrication of organic EL device
The lower electrode (anode), the interlayer insulator, and the second interlayer insulator (partition wall) were formed on the supporting substrate in the same manner as in (3) of Example 3, and subjected to cleaning.
Then, the emitting layer of the organic EL device was formed by inkjet method. The ink used in the inkjet method was prepared by mixing the following materials.
PPV derivative (poly(2-methoxy,
5-(2'-ethyl-hexyoxy)-1,4-phenylenevinylene)): 0.375 wt%
Glycerin: 5 wt%
Diethylene glycol: 10 wt%
Water: 1.231 wt%
Methanol: 23.394 wt%
DMF (N,N-dimethylformamide): 60 wt%
Rhodamine B: 0.0075 wt% (precursor solid content ratio: 2 wt%)
The ink was discharged from the head of an inkjet print device toward the opening in the interlayer dielectric formed on the substrate, and heated at 150°C for four hours in an atmosphere of nitrogen to polymerize the precursor of the composition to obtain a red emitting layer.
The substrate was then transferred to an organic deposition chamber (manufactured by ULVAC, Inc.). Then, tris(8-quinolinol)aluminum (Alq) as the electron injecting material was deposited to a thickness of 20 nm at a deposition rate of 0.1 to 0.3 nm/sec.
The substrate was then transferred to a dehydration unit described below. Specifically, the substrate was transferred to a dry box in which an inert gas such as helium, argon, or nitrogen is circulated and which allows the dew point inside the dry box to be measured and the substrate to be heated on a hot plate inside the dry box.
Dry nitrogen was circulated while heating the substrate at 60°C on the hot plate, and the substrate was held in this state until the dew point decreased to -50°C.
Then, heating using the hot plate was terminated, and the substrate was cooled to room temperature. The substrate was then transferred to an organic deposition vacuum chamber (manufactured by ULVAC, Inc.) while maintaining the environment with a dew point of -50°C, and secured on a substrate holder.
After reducing the pressure inside the vacuum container to $5 \times 10^{-7}$ torr, Al and Li were deposited to a thickness of 150 nm at a deposition rate of 0.5 to 1.0 nm/sec through a mask provided to a tungsten filament so that the cathode AlLi alloy (Li concentration: 10 atm%) was deposited only in the display section. The cathode (upper electrode) had a pattern (number of lines: 240) automatically separated by the partition walls formed on the substrate.

(2) Formation of barrier film
After fabricating the organic EL device on the substrate, a barrier film was deposited on the upper electrode of the organic EL device by facing target sputtering using Corning 1737 as a target. The barrier film was deposited to a thickness of 300 nm at a sputtering pressure of 0.7 Pa and a sputtering output of 1 kW. An organic EL device substrate was thus obtained.

(3) Reliability evaluation and steam transmittance measurement of organic EL display

An organic EL display was produced as described above in which the lower electrodes and the upper electrodes formed an XY matrix. A DC voltage of 10 V was applied between the lower electrode and the upper electrode (lower electrode: (+), upper electrode: (-)). As a result, emission of light occurred at the intersecting point (pixel) of the electrodes.

The organic EL display was subjected to the reliability evaluation and the steam transmittance measurement in the same manner as in Example 1. The results are shown in Table 3.

Example 7

An organic EL display (FIG. 7 (c)) was produced in the same manner as in Example 1 except for using a supporting substrate obtained by depositing the barrier film (thickness: 300 nm) used in Example 1 on each side of polyethersulfone substrate (manufactured by Sumitomo Bakelite Co., Ltd., thickness: 100 $\mu$m) as a plastic film substrate. The reliability evaluation was conducted in the same manner as in Example 1. The results are shown in Table 4.

Comparative Example 8

An organic EL display (FIG. 7 (c)) was produced in the same manner as in Example 7 except for using the polyethersulfone substrate on which the barrier film was not deposited as the supporting substrate. The reliability evaluation was conducted in the same manner as in Example 1. The results are shown in Table 4.

Example 8

The polyethersulfone substrate (opposite substrate) prepared in Example 7, in which the barrier film was deposited on each side, was attached to the organic EL device instead of depositing the barrier film by sputtering (Example 1) to seal the organic EL device.

In more detail, the organic EL device substrate and the polyethersulfone substrate were transferred to a dry box in which dry nitrogen was circulated, and a cat ionicphotocur able adhesive ("3102" manufactured by Three Bond Co., Ltd.) was applied to the periphery of the display section (emitting section) on the organic EL device substrate using a dispenser. The organic EL device substrate and the polyethersulfone substrate were attached by irradiation according to an alignment mark, and an area corresponding to the display section was filled with an inert liquid (fluorinated hydrocarbon: "FC70" manufactured by Sumitomo 3M Ltd.) degassed in advance. The results are shown in Table 4.

TABLE 1

|  |  | Glass | $SiO_2$ | $Al_2O_3$ | $B_2O_3$ | BaO | $Na_2O$ | CaO |
|---|---|---|---|---|---|---|---|---|
| Corning 1737 | Aluminosilicate glass | | 58% | 17% | 8a | 9% | - | 4% |
| Pyrex | Borosilicate glass | | 81% | 2% | 13% | - | 4% | - |

TABLE 2

|  | O | Si | B | Al | Ba | Na | Ca | Ce |
|---|---|---|---|---|---|---|---|---|
| Elemental analysis values of target of Example 1 | 64% | 20% | 5% | 7% | 1% | - | 2% | - |
| Elemental analysis values of barrier film of Example 1 | 62% | 19% | 6% | 8% | 2% | - | 20 | - |
| Elemental analysis values of barrier film of Example 2 | 63% | 26% | 6% | 1% | - | 3% | - | - |
| Elemental analysis values of barrier film of Example 5 | 61% | 24% | 6% | 1% | - | 2% | - | 5% |

TABLE 3

| | Application | Display type | Organic EL | Target | Gas | Pixel reduction rate | Steam transmittance $(g/m^2 \cdot 24hr)$ |
|---|---|---|---|---|---|---|---|
| Example 1 | Encapsulation for EL device | Top emission | Low molecular weight | Corning 1737 | Ar: 100% | 3% | <0.01 |
| Example 2 | | | | Pyrex | Ar: 100% | 5% | <0.01 |
| Comparative Example 1 | | | | No barrier film | | 100% | - |
| Comparative Example 2 | | | | Glass plate (50 μm thick) | | Reduced from periphery | |
| Example 3 | Barrier for color conversion layer | Bottom emission | | Corning 1737 | Ar: 100% | 3% | <0.01 |
| Example 4 | | | | Pyrex | Ar: 100% | 5% | <0.01 |
| Example 5 | | | | Pyrex and $CeO_2$ | Ar: 100% | 3% | <0.01 |
| Comparative Example 3 | | | | $SiO_2$ | Ar: 100% | 80% | 1 |
| Comparative Example 4 | | | | SiO | Ar: 90% $N_2$: 10% | 80% | 1 |
| Comparative Example 5 | | | | $SiO_2$ and $Al_2O_3$ | Ar: 100% | 20% | 0.5 |
| Comparative Example 6 | | | | $SiO_2$ and $CeO_2$ | Ar: 100% | 10% | 0.1 |
| Comparative Example 7 | | | | No barrier | film | 100% | - |
| Example 6 | Encapsulation for EL device | | High molecular | Corning 1737 | Ar: 100% | 4% | <0.01 |

TABLE 4

| | Application | Display type | Organic EL | Target | Gas | Pixel reduction rate |
|---|---|---|---|---|---|---|
| Example 7 | Barrier film of plastic supporting substrate | Top emission | Low molecular weight | Corning 1737 | Ar gas | 30% |
| Comparative Example 8 | | | | No barrier film | | 100% |
| Example 8 | Barrier film of plastic opposite substrate | | | Corning 1737 | Ar gas | 30% |

As is clear from Tables 3 and 4, it was confirmed that an organic EL display exhibiting excellent durability was obtained according to the examples of the invention.

INDUSTRIAL APPLICABILITY

The barrier film according to the invention can be used for consumer and industrial displays such as light-emitting displays for portable telephones, PDAs, car navigation systems, monitors, TVs, and the like.

**Claims**

1. A method for producing a barrier film for light-emitting displays comprising a glass material comprising three or more components, the method comprising forming the barrier film by a vapor deposition method.

2. The method according to claim 1, wherein a raw material for the barrier film is the glass material comprising three or more components.

3. The method according to claim 2, wherein the glass material of the raw material comprises at least silicon, boron, and aluminum.

4. The method according to claim 2 or 3, wherein the glass material of the raw material comprises at least silicon oxide, boron oxide, and aluminum oxide.

5. The method according to claim 2 or 3, wherein the glass material of the raw material comprises at least silicon oxide, boron oxide, aluminum oxide, and an alkali metal oxide or an alkaline earth metal oxide.

6. The method according to claim 1, wherein the glass material of the raw material of claim 5 and a rare earth element metal oxide are used in combination.

7. The method according to claim 4, wherein the glass material of the raw material comprises 50 to 90 wt% of the silicon oxide, 5 to 20 wt% of the boron oxide, and 1 to 10 wt% of the aluminum oxide.

8. The method according to claim 2 or 3, wherein the barrier film is formed by a sputtering method with a target comprising the glass material of the raw material.

9. The method according to any one of claims 1 to 3, wherein the barrier film is a barrier film for organic electroluminescent displays.

10. A barrier film for light-emitting displays produced by the method according to any one of claims 1 to 3.

11. The barrier film according to claim 10, having a water vapor transmission rate of less than 0.01 g/m$^2$·24hr.

12. A color conversion substrate for light-emitting displays comprising a supporting substrate, a color conversion layer which converts and/or adjusts the color of received light, and the barrier film of claim 10 in this order.

13. A light-emitting display comprising a supporting substrate, a color conversion layer which converts and/or adjusts the color of received light, the barrier film of claim 10, and an emitting layer in this order.

14. A light-emitting display comprising a supporting substrate, an emitting layer, and the barrier film of claim 10 in this order.

15. A supporting substrate or opposite substrate for light-emitting displays wherein the barrier film of claim 10 is formed on a one side or both sides of the substrate.

16. The supporting substrate or opposite substrate according to claim 15 being a plastic substrate.

17. The light-emitting display according to any one of claims 12 to 14 wherein the supporting substrate is a glass substrate or the supporting substrate of claim 16.

FIG. 1

(a)

(b)

FIG. 2

FIG. 3

(a)

(b)

(c)

FIG. 4

(a)     Stack α-Si layer on substrate

(b)     Crystallization by laser annealing
            **KrF(248nm)**

(c)     Pattern polysilicon layer

(d)     Stack gate insulating layer

(e)     Stack Al or polysilicon layer

(f)     First anodic oxidation

Photoresist

(g)     Pattern gate Al

(h)     Second anodic oxidation

Ion doping

(i)     Ion doping

FIG. 5

FIG. 6

FIG. 7

(a)

(b)

(c)

<div align="center">

**INTERNATIONAL SEARCH REPORT**

</div>

| | International application No. |
|---|---|
| | PCT/JP2004/016108 |

**A. CLASSIFICATION OF SUBJECT MATTER**
Int.Cl⁷ H05B33/04, H05B33/02, H05B33/12, H05B33/14

According to International Patent Classification (IPC) or to both national classification and IPC

**B. FIELDS SEARCHED**

Minimum documentation searched (classification system followed by classification symbols)
Int.Cl⁷ H05B33/00-33/28

Documentation searched other than minimum documentation to the extent that such documents are included in the fields searched
Jitsuyo Shinan Koho          1922-1996   Jitsuyo Shinan Toroku Koho   1996-2005
Kokai Jitsuyo Shinan Koho    1971-2005   Toroku Jitsuyo Shinan Koho   1994-2005

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 9-330793 A  (Idemitsu Kosan Co., Ltd.), 22 December, 1997 (22.12.97), | 1-5,7-13, 15-16 |
| Y | Par. Nos. [0011] to [0073]; Fig. 8 (Family: none) | 6,14,17 |
| Y | JP 2001-244069 A  (Seiko Epson Corp.), 07 September, 2001 (07.09.01), Par. No. [0024] (Family: none) | 6,14,17 |
| Y | JP 11-97169 A  (Casio Computer Co., Ltd.), 09 April, 1999 (09.04.99), Par. Nos. [0029] to [0053]; Fig. 1 (Family: none) | 1-17 |

☒ Further documents are listed in the continuation of Box C.       ☐ See patent family annex.

| | | |
|---|---|---|
| * Special categories of cited documents: | "T" | later document published after the international filing date or priority date and not in conflict with the application but cited to understand the principle or theory underlying the invention |
| "A" document defining the general state of the art which is not considered to be of particular relevance | | |
| "E" earlier application or patent but published on or after the international filing date | "X" | document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" document referring to an oral disclosure, use, exhibition or other means | | |
| "P" document published prior to the international filing date but later than the priority date claimed | "&" | document member of the same patent family |

| Date of the actual completion of the international search | Date of mailing of the international search report |
|---|---|
| 03 March, 2005 (03.03.05) | 22 March, 2005 (22.03.05) |

| Name and mailing address of the ISA/ | Authorized officer |
|---|---|
| Japanese Patent Office | |
| Facsimile No. | Telephone No. |

Form PCT/ISA/210 (second sheet) (January 2004)

**INTERNATIONAL SEARCH REPORT**

| International application No. |
|---|
| PCT/JP2004/016108 |

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2003-225970 A (KRI International, Inc.), 12 August, 2003 (12.08.03), Par. Nos. [0006] to [0016], [0023] (Family: none) | 1-17 |

Form PCT/ISA/210 (continuation of second sheet) (January 2004)